# EUROPÄISCHE PATENTSCHRIFT

(11) **EP 0 865 664 B1**
(45) Veröffentlichungstag und Bekanntmachung des Hinweises auf die Patenterteilung: **22.09.2004**
(21) Anmeldenummer: 97911131.7
(22) Anmeldetag: 06.10.1997
(51) Int. Cl.: H01L 21/3065, H01L 21/321, H01L 21/308

(54) **VERFAHREN ZUM ANISOTROPEN PLASMAÄTZEN VERSCHIEDENER SUBSTRATE**
PROCESS FOR ANISOTROPIC PLASMA ETCHING OF DIFFERENT SUBSTRATES
PROCEDE DE GRAVURE ANISOTROPE AU PLASMA DE DIFFERENTS SUBSTRATS

(30) Priorität: 07.10.1996 DE 19641288
(43) Veröffentlichungstag der Anmeldung: 23.09.1998
(73) Patentinhaber: ROBERT BOSCH GMBH, 70442 Stuttgart (DE)
(72) Erfinder: LÄRMER, Franz, D-70437 Stuttgart (DE); SCHILP, Andrea, D-73525 Schwäbisch Gmünd (DE)
(86) Internationale Anmeldenummer: PCT/DE1997/002272
(87) Internationale Veröffentlichungsnummer: WO 1998/015972

(56) Entgegenhaltungen:
- DE-A- 3 940 083
- DE-A- 4 132 564
- US-A- 4 343 677
- US-A- 4 432 132
- US-A- 4 784 720
- US-A- 5 100 505

## Beschreibung

### Stand der Technik

Die Erfindung geht aus von einem Verfahren zum anisotropen Plasmaätzen von Substraten gemäß dem Oberbegriff des Anspruchs 1.

Die Strukturierung von Silicium mittels Plasmaätzverfahren ist bekannt. Bei Plasmaätzverfahren werden in einem Reaktor mit Hilfe einer elektrischen Entladung in einem Reaktivgasgemisch chemisch reaktive Ätzspezies und elektrisch geladene Teilchen, also Ionen, erzeugt. Die so erzeugten, positiv geladenen Ionen werden durch eine elektrische Vorspannung, die am Siliciumsubstrat anliegt, zum Substrat hin beschleunigt und fallen annähernd senkrecht auf die Substratoberfläche ein, wobei sie auf dem Ätzgrund die chemische Umsetzung der reaktiven Ätzspezies mit Silicium fördern. Man unterscheidet zwischen dem ioneninduzierten anisotropen Plasmaätzen, bei dem die Ätzwirkung der Ätzspezies an einen energetischen Ionenfluß zur Substratoberfläche gekoppelt ist und dem spontanen, isotropen Plasmaätzen, bei dem die Ätzspezies keiner oder nur sehr geringer Ionenunterstützung bedürfen. Das ioneninduzierte Plasmaätzen, das im Falle von Silicium als zu strukturierendem Material vorzugsweise mit weniger reaktionsfreudigen Halogenen wie Chlor oder Brom durchgeführt wird, weist vergleichsweise geringe Abtragsraten auf und ist extrem anfällig gegenüber Feuchte und Plasmaverunreinigungen. Das spontane Plasmaätzen, das im Falle von Silicium als zu strukturierendem Material vorwiegend mit Fluorgasen durchgeführt wird, weist dagegen hohe Abtragsraten auf und kann darüber hinaus auf Ionen hoher Energie verzichten. Dadurch sind bei der Suche nach geeigneten Maskenmaterialien lediglich chemische Gesichtspunkte hinsichtlich der Selektivität zwischen Maskierung und zu ätzendem Stoff zu berücksichtigen, wodurch die Auswahlmöglichkeiten wesentlich erweitert werden. Im Falle anderer zu strukturierender Materialien als Silicium ist in vielen Fällen überhaupt nur mit spontan agierender Plasmachemie eine Maskierung möglich. Das Ausmaß erreichbarer Maskenselektivität kann mit diesem Ansatz sehr hoch sein, da bei kleinen Ionenenergien kein oder nur sehr geringer ioneninduzierter oder physikalischer Maskenabtrag stattfindet und rein chemische Reaktionen ausgeprägt materialselektiv sind. Ebenfalls aufgrund der geringen Ionenenergien findet eine Mikromaskierung durch Zerstäubung und Redeposition von abgestäubtem oder zu einem nicht flüchtigen Produkt reagierenden Maskenmaterial auf den Ätzflächen praktisch nicht statt, so daß glatte Ätzflächen ohne störende Strukturen entstehen. Spontan agierende Ätzspezies werden dennoch in Plasmaprozessen kaum oder nur ungern angewendet, da sie aufgrund ihres spontanen Reaktionsverhaltens isotrop, also auch unter den Maskenrändern, ätzen. Für eine genaue Strukturübertragung ist eine hohe Anisotropie ohne Unterätzung der Maske aber zwingend erforderlich.

Eine bekannte Möglichkeit zur Kombination der Vorteile von spontanem und ioneninduziertem Plasmaätzen besteht in der Verwendung eines Seitenwandschutzes durch während des Prozesses abgeschiedenen Dünnfilm. Aus dem Plasma heraus wird die Seitenwand der zu ätzenden Strukturen, auf die nur wenige Ionen einfallen, durch einen Film von anorganischen oder organischen, zum Beispiel polymerem Material, beschichtet und dadurch vor dem Angriff der spontan agierenden Ätzspezies geschützt. Der Ätzgrund bleibt durch gleichzeitige Einwirkung eines hohen Flusses von Ionen niedriger Energie frei von diesem Schutzfilm und kann daher mit hoher Geschwindigkeit geätzt werden. Dadurch werden anisotrope Profile erhalten und Unterätzungen der Maskenränder vermieden. Als nachteilig erweist sich jedoch bei gleichzeitiger Anwesenheit von schützenden, das heißt passivierenden, und aggressiven, das heißt ätzenden Spezies im Plasma, daß eine starke Rekombination der ungesättigten Passivier- mit den spontan agierenden Ätzspezies diese paarweise eliminiert, indem ein inertes Reaktionsprodukt gebildet wird, was die Dichte der zur Verfügung stehenden aktiven Spezies stark reduziert. Um diese Rekombination von Atz- und Passivierspezies zu verhindern, werden diese Spezies nach einem Teilaspekt des erfindungsgemäßen Verfahrens getrennt voneinander und alternierend eingesetzt. Da jedoch während der Ätzschritte jeweils ein neuer Seitenwandbereich freigelegt wird, der erst beim nächsten Passivierschritt wieder bedeckt und geschützt werden kann, wäre bei diesem Vorgehen normalerweise eine entsprechend stark ausgeprägte Riefelung der Seitenwand die Folge. Dieser Effekt ist äußerst unerwünscht und würde diese Methode an sich unbrauchbar machen; die Riefelung könnte nach diesem Ansatz nur dadurch vermieden werden, daß die Weite und damit die Zeitdauer des einzelnen Ätzschrittes sehr klein gewählt wird, wodurch aber wieder eine sehr geringe Ätzgeschwindigkeit oder extrem häufiger, kurzzeitiger Wechsel zwischen Ätzen und Passivieren resultiert, was wegen der Gasvolumina in den zuführenden Leitungen und der Plasmakammer auch gar nicht durchführbar wäre, was diese letztere Methode ebenfalls unbrauchbar macht.

### Vorteile der Erfindung

Das erfindungsgemäße Verfahren mit den im Hauptanspruch genannten Merkmalen weist demgegenüber den Vorteil auf, daß spontan reagierende Ätzspezies eingesetzt werden, die mit hohen Abtragraten eine Vielzahl von Materialien, insbesondere Polymere, Metalle oder Mehrkomponentensysteme, anisotrop strukturieren können. In vorteilhafter Weise können schwer ätzbare Substanzen, die bei Raumtemperatur nur wenig flüchtige Verbindungen ausbilden und daher in herkömmlicher Weise durch Einsatz hoher Ionenenergien zerstäubt werden müssen, bei erhöhter Temperatur und niedriger Ionenenergie anisotrop strukturiert werden.

Die Erfindung sieht vor, die während eines Seitenwandpassivierschrittes aufgebrachte Seitenwandpassivierschicht während des Ätzvorgangs zu einem großen Teil, aber nicht vollständig, wieder abzutragen. Das abgetragene Material verbleibt während des Ätzvorgangs in unmittelbarer Nähe beziehungsweise vor der Seitenwand und wird durch die Art des Abtrags in Richtung des Ätzvorganges vorwärtsgetrieben, wobei es sich unterhalb der ursprünglichen Seitenwandpassivierungskante wieder niederschlagen kann. Die ursprüngliche Seitenwandpassivierschicht wird also abgedünnt und nach unten über die bei Fortschreiten der Ätzung neu entstehenden Seitenwandflächen gezogen, so daß diese unmittelbar bei Freilegung, nicht erst beim nächsten Seitenwandpassivierschritt, geschützt werden. Bei der nächsten Seitenwandpassivierung wird dann jeweils die ursprüngliche und die über der neu gebildeten Seitenwandfläche befindliche Passivierschicht wieder etwa auf die ursprüngliche Dicke verstärkt, bevor erneut geätzt und die Schicht dabei wieder ein Stück nach unten gezogen wird. Durch diesen Effekt wird ein an sich isotroper Ätzeffekt lokal, nämlich in unmittelbarer Nähe der Passivierschichtunterkante, anisotrop gemacht. Das Vorwärtstreiben der Seitenwandpassivierschicht wird dabei vorwiegend durch eine genau bemessene Dosis / einen genau bemessenen Anteil von Ionen bewirkt, der nicht exakt senkrecht auf den Strukturgrund einwirkt, sondern unter einem kleinen Winkel einfällt und daher auf die Seitenwandpassivierschicht trifft. Ein gewisser Anteil schräg einfallender Ionen ist bei Plasmaätzprozessen stets gegenwärtig und normalerweise äußerst unerwünscht, da er zu einer ioneninduzierten Seitenwandätzung und damit Maskenrandunterschneidung führt, was einem Verlust an Anisotropie und Strukturtreue gleichkommt. Beim erfindungsgemäßen Verfahren wird gerade ein genau bemessener Schrägeinfall von Ionen dazu benutzt, um den Schutzfilm kontrolliert vorwärts zu treiben. Ein inhärenter Störeffekt wird so durch Wahl geeigneter Bedingungen unter Kontrolle gebracht und zum Vorteil eingesetzt.

In vorteilhafter Weise werden also die Vorteile isotrop, das heißt spontan agierender Ätzspezies, beibehalten und um das Merkmal der Anisotropie erweitert. Durch die getrennte Anwendung von Ätz- und Passivierspezies in verschiedenen Verfahrensschritten wird die Rekombination und paarweise Auslöschung chemisch aktiver Spezies verhindert. Da spontan agierende Ätzspezies mit sehr hohen Ätzraten eingesetzt werden können, werden die Abtragraten typischer ioneninduzierter Prozesse weit übertroffen.

Das erfindungsgemäße Verfahren erweist sich als besonders vorteilhaft, wenn geeignete Maskenmaterialien für schwierige zu ätzende Substanzen gesucht werden, da die Randbedingungen der Maskenauswahl bei spontan agierender Chemie wesentlich weniger Einschränkungen mit sich bringen. Erfindungsgemäß werden nur Ionen geringer Energie eingesetzt, so daß sich eine hohe Selektivität gegenüber einer breiten Palette von Maskenmaterialien ergibt. Da die Ionen geringer Energie das Maskenmaterial nicht schädigen, brauchen bei der Auswahl der Maskenmaterialien nur deren chemische Eigenschaften berücksichtigt zu werden. Ein ioneninduzierter Maskenabtrag oder Zerstäubung sowie Redeposition der Maske treten kaum auf.

In besonders vorteilhafter Weise kann mit dem erfindungsgemäßen Verfahren anisotrop geätzt werden, wobei gegenüber dem zu ätzenden Material möglichst aggressive, unspezifische, spontan agierende Atzspezies verwendet werden. Dabei ist es beispielsweise möglich, als Mehrfachkomponentensysteme ausgeführte Substrate, Metalle oder Polymere zu ätzen. Im Zusammenhang mit der vorliegenden Erfindung wird unter einem Mehrkomponentensystem ein Substrat verstanden, das aus unterschiedlichen Materialbestandteilen, zum Beispiel Gallium/Arsen oder Gallium/Aluminium/Arsen aufgebaut ist. Vielen Mehrkomponentensystemen ist gemeinsam, daß ein anisotropes Ätzen mit den dafür herkömmlicherweise verwendeten ioneninduzierten Ätzspezies nur schwierig durchzuführen ist und niedrige Abtragsraten aufweist. Anisotropes Ätzen in Mehrkomponentensystemen erfordert vielmehr ein durch die vorliegende Erfindung ermöglichtes unspezifisches Ätzen der verschiedenen Materialbestandteile, wobei sich während des Ätzvorgangs keine Anreicherung von beispielsweise Gallium, Aluminium oder Arsen auf dem Strukturgrund bildet. In besonders bevorzugter Weise können Substrate aus Gallium/Arsen oder Gallium/Aluminium/Arsen bei dem erfindungsgemäßen Verfahren mittels Chlor anisotrop strukturiert werden. Die Erfindung sieht vor, daß in einer derartigen Ausführungsform Passiviergase wie CCl₄, CHCl₃, CₓH_{y}Cl_{z} oder BCl₃, eventuell in Verbindung mit SiCl₄ für die GaAs/AlGaAs-Ätzung verwendet werden. Diese Passiviergase führen zur Bildung geeigneter stabiler Seitenwandpassivierschichten, die organische Chlorkohlenstoffe, Chlorkohlenwasserstoffe oder das BCl₃-Analagon enthalten und gegebenenfalls durch ein Siliciumgerüst vernetzt werden (bei Zusatz von SiCl₄).

Die Erfindung sieht vorteilhafterweise auch vor, Polymerschichten, vorzugsweise dicke Polymerschichten wie dicke Lacke (Photoresist, Festresist) anisotrop zu ätzen. Die maßgenaue Strukturierung dikker Polymere mit hohem Aspektverhältnis, das heißt, großer Tiefe und geringen Strukturbreiten, zum Beispiel >20:1, und senkrechten Seitenwänden ist ein Schlüsselprozeß für additive Verfahren, wo solche Strukturen auf IC-Wafern zunächst als Negativ erzeugt und galvanisch wiederaufgefullt werden. Nach dem Entfernen der Polymerform verbleibt zuletzt ein freibewegliches Sensorelement -das Positiv durch die "Abformung"- auf aktiver (IC-)Chipfläche, ohne daß ein Eingriff in den Schaltungsprozeß erforderlich ist. Solche additiven Verfahren werden bei der Herstellung von integrierten Sensoren immer wichtiger. Zur Bildung der spontan agierenden Ätzspezies wird vorzugsweise Sauerstoff oder Sauerstoff kombiniert mit fluorliefernden Gasen wie Schwefelhexafluorid (SF₆) oder Stickstofftrifluorid (NF₃) verwendet. Die eigentlichen Ätzspezies sind dann Fluor- und Sauerstoff-Radikale. Die Seitenwandpassivierschicht muß zum Schutz vor dem Ätzprozeß deutlich anders aufgebaut sein als die zu atzenden Polymerschichten, aber dennoch einen "weichen" Charakter behalten, um während der Ätzschritte vorwärtsgetrieben werden zu können. Die Seitenwandpassivierschicht enthält daher vorzugsweise neben einem Kohlenstoffgerüst zusätzliche Elemente, die dem Ätzplasma Widerstand leisten, wie beispielsweise Silicium. Silicium enthaltende Polymergerüste, besonders in oxidischer oder azidischer Bindung, sind gegenüber Sauerstoff und Fluor widerstandsfähig und verhindern einen Ätzprozeß an der Polymerseitenwand, erlauben aber einen kontrollierten Abtrag und ein vorwärtstreiben des Schutzfilms. Erfindungsgemäß sind auch metallhaltige Kohlenwasserstoffe oder Kohlenwasserstoffe mit einem hohen Anteil an aromatischen Ringen (n-Phenyle) als Seitenwandpassiviergase geeignet. In besonders bevorzugter Weise werden Monosilan SiH₄, HMDS (Hexamethyldisilan), HMDSO (Hexamethyldisiloxan) oder HMDSN (Hexamethyldisilazan) verwendet, wobei zusätzlich SiF₄ als "Vernetzer" zugefügt werden kann, um ein Siliciumgerüst zu erzeugen. Auch ein Gemisch von Fluorkohlenwasserstoffen und SiF₄ oder SiH₄ führt in entsprechender Weise zur Ausbildung eines siliciumhaltigen organischen Polymermaterials, das den Verfahrensansprüchen genügt (CₓF_{y}H_{z} + w·SiF₄ → Cₓ,F_{y},H_{z},Si_{w} + HF,F,CF (Siliciumfluorkohlenwasserstoff) + F) (entsprechend für SiH₄ statt SiF₄). Als Maskierschichten können dann beispielsweise dünne Metallmasken aus Aluminium, Chrom, Nickel etc. oder Plasma-CVD- oder Oxid-Schichten wie Al₂O₃ etc. eingesetzt werden.

### Zeichnung

Die Erfindung wird anhand von Zeichnungen näher erläutert. Es zeigen:
- Figur 1: schematisch das Aufbringen einer Seitenwandpassivierschicht,
- Figur 2: schematisch den Ätzvorgang mit gleichzeitigem Vorantreiben der Seitenwandpassivierschicht und
- Figur 3: schematisch eine erfindungsgemäß geeignete Ionenverteilung.

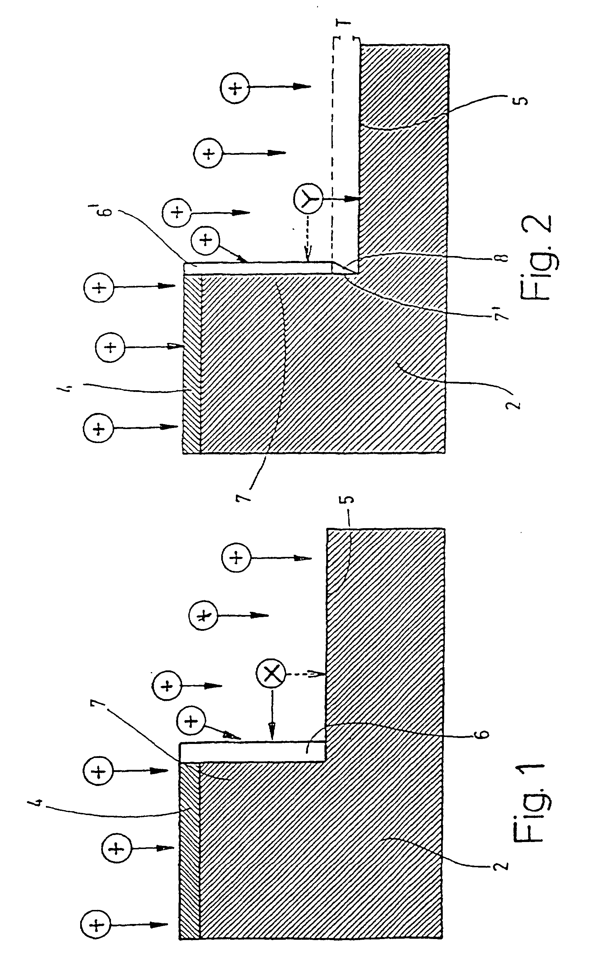

Die Figur 1 zeigt ein Gallium/Arsen-Substrat 2, das mit einer aus beispielsweise Photolack hergestelltem Ätzmaske 4 beschichtet ist, wobei die Ätzmaske 4 den Bereich 5 des Substrats 2 freiläßt, der anisotrop eingeätzt werden soll. Die Passivierung der Seitenwand 7 wird mittels eines Passiviergases (x im Oval) durchgeführt, das zum Beispiel ein Gemisch aus BCl₃ und SiCl₄ oder CCl₄ und BCl₃ etc. sein kann. Das Gemisch besitzt einen Gasfluß von 10 - 100 sccm und einen Prozeßdruck von 20 µbar = 2 Pascal. Über eine Einkopplungsvorrichtung für elektromagnetische Felder, zum Beispiel Mikrowellen wird bei einer Leistung zwischen 500 - 1000 W ein Mikrowellen- oder ein Hochfrequenzfeld eingestrahlt und damit ein hochdichtes Plasma erzeugt. Während der Passivierung kann gleichzeitig eine Einwirkung von Ionen geringer Energie (+ im Oval) auf die Substrate bewirkt werden. Dadurch wird erreicht, daß auf dem Ätzgrund 5 keine Passivierschicht aufgetragen wird. Die passivierenden Monomere reichern sich bevorzugt an den Seitenwänden 7 an und bilden dort die Seitenpassivierschicht 6. Der Ioneneinfall auf Substrat 2 mit Ionen geringer Energie wird mittels einer Substratelektrode kontrolliert. Dazu wird die Substratelektrode mit einer Hochfrequenzleistung von zum Beispiel 10 W, die eine Substratvorspannung von zum Beispiel 30 V ergibt, beaufschlagt. Die Ionenenergie beträgt dann zum Beispiel ca. 40 eV.

Alternativ kann auch vorgesehen sein, daß während des Passivierschrittes auf eine Bestrahlung mit Ionen geringer Energie verzichtet wird. Während des Passivierschrittes werden also nicht nur die Seitenwand 7, sondern auch der Ätzgrund 5 gleichmäßig mit einer Passivierschicht bedeckt. Die auf dem Ätzgrund 5 aufgebrachte Passivierschicht wird während des darauffolgenden Ätzvorgangs rasch durchbrochen, da die Passivierschicht mit der Ionenunterstützung des Ätzschrittes sehr schnell abgetragen wird. Die Seitenwand 7 der einzuätzenden Struktur wird nur in vergleichweise geringem Ausmaß von Ionen getroffen, so daß diese während des Ätzvorganges durch die Seitenwandpassivierschicht geschützt bleibt. Der Seitenwandeinfall ist aber wichtig für die Erzielung des Vorwärtstreibens des Seitenwandfilms. Er wird kontrolliert durch die Dichte der Ionen, ihrer Beschleunigung zum Substrat und durch den Druck (Stoßraten).

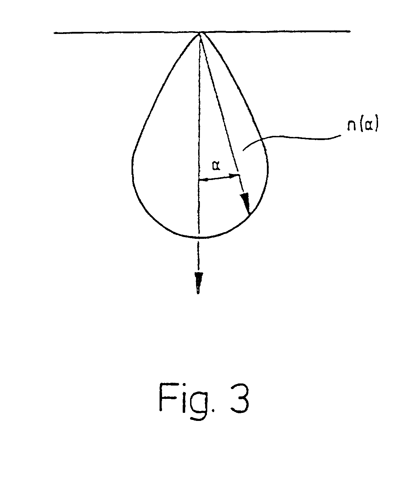

Die Figur 2 verdeutlicht den Ätzvorgang des erfindungsgemäßen Verfahrens. Unter dem Einfluß einer Ionenstrahlung geringer Energie (+ im oval) wird das Substrat 2 der Ätzchemie, dem Atzplasma, ausgesetzt. Dazu wird ein gegenüber dem Substratmaterial spontan agierendes Ätzspezies, zum Beispiel Chlor (y im Oval), eingesetzt, das einen Gasfluß zwischen 50 - 200 sccm und einen Prozeßdruck zwischen 10 und 30 µbar (= 1-3 Pa) aufweist. Die Plasmaerzeugung erfolgt hierbei vorzugsweise mit einer Hochfrequenz- oder Mikrowelleneinstrahlung bei Leistungen zwischen 300 - 1200 w. An der Substratelektrode liegt eine Substratvorspannung zur Ionenbeschleunigung vor. Die Substratvorspannung liegt vorzugsweise zwischen 30 - 40 V und kann mit einer Hochfrequenzeinspeisung bei Leistungen zwischen 10 - 15 W erreicht werden. Während des Ätzvorganges werden mit Hilfe der elektrischen Entladung chemisch reaktive Spezies und elektrisch geladene Teilchen in einem hochdichten Plasma erzeugt. Die so erzeugten positiv geladenen Ionen werden durch die an der Substratelektrode angelegte elektrische Vorspannung zum Substrat 2 hin beschleunigt, fallen annähernd senkrecht auf die durch die Ätzmaske 4 freigelassene Substratoberfläche 5 ein und unterstützen die chemische Umsetzung des reaktiven Plasmaspezies mit dem Gallium/Arsen-Substrats 2. Das reaktive Plasmaspezies ätzt isotrop und unspezifisch das Mehrkomponentensystem weg. Die Seitenwand 7 des Substrates 2 wird durch die Seitenwandpassivierschicht 6 geschützt. Da Chlor gegenüber AlGaAs (nicht gegenüber Silicium, wie in der Einleitung beschrieben) ein spontan agierendes Ätzspezies darstellt, kann auf eine Initiierung oder Unterstützung durch Ioneneinfall für den Ätzvorgang an sich verzichtet werden. Der Ioneneinfall ist jedoch notig, um die Seitenwandpassivierschicht 6 voranzutreiben, den Ätzgrund 5 von Depositionen aus dem Plasma freizuhalten und, falls während der Passivierung auf Ionenunterstützung verzichtet wurde, die auf dem Atzgrund 5 befindliche Passivierschicht abzutragen und zu durchbrechen. Unter einem kleinen Winkel zu senkrecht einfallende Ionen (Winkel α in Figur 3) einfallende und daher auf die Seitenwandpassivierschicht 6 auftreffende Ionen unterstützen den Abtrag der teilweisen Seitenwandpassivierschicht 6 und führen zu deren Verdünnung 6'. Wahrend des Atzvorganges wird der Ätzgrund 5 um die Tiefe T nach unten weggeätzt, so daß eine ursprünglich von der Seitenwandpassivierschicht 6 nicht bedeckte Flache 7' der Seitenwand 7 gebildet wird. Die durch die überwiegend durch schräg einfallende Ionen freigesetzten Polymercluster der Seitenwandpassivierschicht 6 haben die Tendenz, sich unmittelbar benachbart niederzuschlagen und bedecken nun als Anteile der ursprünglichen Seitenwandpassivierschicht 6 enthaltende Passivierschicht 8 die freigelegte Fläche 7' der Seitenwand 7, so daß diese bereits unmittelbar bei Freilegung, nicht erst beim nächsten Passivierschritt, geschützt wird. Ein isotropes Anätzen der Fläche 7' und damit eine Riefelung der Seitenwand wird vermieden.

Der kontrollierte Schrägeinfall niederenergetischer Ionen auf die Substratoberfläche wird erreicht durch eine Kombination von Prozeßdruck, Plasmadichte und damit Stoßrate im Plasma (das heißt, Höhe der eingestrahlten HF- (Hochfrequenz) beziehungsweise Mikrowellenleistung in die hochdichte Plasmaquelle) und der Ionenbeschleunigungsspannung an der Substratelektrode sowie deren zeitliches Verhalten. Bei Prozeßdrücken zwischen 10 und 100 µbar, vorzugsweise von 20 µbar, sowie bei einer hohen Ionendichte von 2 x 10¹¹ cm⁻³ bis 5 x 10¹² cm⁻³, vorzugsweise von 1 x 10¹² cm⁻³, bildet sich ein divergenter Ionenfluß aus infolge der gegenseitigen Abstoßung der positiv geladenen Spezies von sehr hoher Dichte, sowie infolge einer Diffusion von Ionen aus Bereichen hoher Ionendichte in Bereiche niedriger Ionendichte, wie sie um den Wafer herum liegen. Dieser divergente Ionenfluß zum Substrat wird durch die Beschleunigungsspannung zum Substrat hin wiederum gebündelt, so daß ein mehr oder weniger eng gerichteter Ionenstrom auf die Substratelektrode einfällt. Je höher die Ionenbeschleunigungsspannung in Relation zur Ionendichte gewählt wird, umso schärfer gebündelt erscheint die Richtungsverteilung (Figur 3:n(α)) der Ionen, das heißt, umso weniger schrägeinfallende Ionen werden beobachtet. Die Anzahl der Ionen bei einem bestimmten Winkel α verringert sich und verschiebt sich in Richtung kleinerer Winkel (Fig. 3). Mit höherer Engergie nimmt aber auch die Abtragswirkung der Ionen, das heißt ihre Zerstörungskraft für den Seitenwand-Film, beim Schrägeinfall auf die Seitenwand zu, was deren geringere Anzahl unter diesem Winkel zum Teil wiederum kompensiert. Infolgedessen steht ein relativ breites Prozeßfenster zur Verfügung, in dem der Mechanismus brauchbar funktioniert (Spannungen zwischen 10 und 100 V, vorzugsweise 30 - 50 V) und der Einfluß auf das Prozeßergebnis eine stetige Funktion ist, was eine einfache Optimierung über die Profilform ermöglicht. Wird die Substratvorspannung wie allgemein üblich durch eine HF-Leistung an der Substratelektrode bewirkt, ist auch der Ionenfluß im Bereich der Nulldurchgänge dieser HF-Spannung zu berücksichtigen, innerhalb dem jeweils sehr niederenergetische Ionen mit hoher Divergenz auf die Waferoberflache einfallen und diese entladen (Plasma hoher Dichte).

Der Ätzschritt kann beispielsweise solange durchgeführt werden, bis eine Atztiefe von ca. 2 bis 3 µm Tiefe erreicht ist. Dies erfordert bei den hohen Abtragsraten aus hochdichten Plasmen eine Zeit für den Ätzschritt von zum Beispiel 6 Sekunden bis 1 Minute.

In einem daran anschließenden Passivierungsschritt wird dann jeweils die letztmalig aufgetragene verdünnte Seitenwandpassivierschicht 6' und die über der neugebildeten Seitenwandfläche 7' befindliche Passivierschicht 8 wieder auf die ursprüngliche Dicke der Seitenwandpassivierschicht 6 verstärkt, bevor erneut geätzt und die Seitenwandpassivierschicht 6 wieder ein Stück nach unten verlagert wird. Der Ätzvorgang und die Passivierung wird so oft alternierend wiederholt, bis die vorherbestimmte Ätztiefe der Strukturen im Substrat erreicht ist. Die Dauer der einzelnen Ätzvorgänge liegt zum Beispiel bei einem mikrowellenunterstützten Verfahren (zur Erzeugung hochdichten Plasmas), das eine Ätzrate zwischen 2 und 20 µm/min. ermöglicht, so, daß pro Ätzschritt zum Beispiel 2 bis 3 µm Tiefe weitergeätzt wird. Die Passivierung wird solange durchgeführt, bis eine ca. 5 - 200 nm, vorzugsweise 50 nm, starke Seitenwandpassivierschicht 6 abgeschieden ist, die sich aus den beschriebenen Spezies zusammensetzt. Dafür wird in der Regel eine Zeit von 5 Sekunden bis zu 1 Minute benötigt.

In vorteilhafter Weise kann ein anisotropes Ätzen mit sehr geringen Ionenenergien erreicht werden. Soll während der Passivierung auf dem Ätzgrund 5 keine Passivierschicht aufgetragen werden, genügen dazu im Prinzip bereits Ionenenergien von nur ca. 10 - 20 eV. Während des Ätzvorganges ist erfindungsgemäß vorgesehen, eine Ionenbestrahlung mit Energien zwischen 30 und 50 eV durchzuführen, um den Strukturgrund von Depositionen aus dem Plasma freizuhalten und die Seitenwandfilmdynamik aufrechtzuerhalten.

Da das erfindungsgemäße Verfahren hohe Atzraten vorsieht, kann es zu einer Erwärmung des Substrates kommen. Daher ist es notwendig, für eine Kühlung der Substrate zu sorgen. Dies kann beispielsweise durch Kühlung der Substratrückseite durch einen Heliumgasstrom, durch ein Elastomer oder durch Aufkleben der Substrate auf eine gekühlte Elektrode erreicht werden.

Erfindungsgemäß ist es wesentlich, daß die eingesetzten Plasmaquellen hohe Dichten von reaktiven Spezies und Ionen bei gleichzeitig geringer, aber exakt kontrollierbarer Energie, mit der die erzeugten Ionen die Substrate erreichen, aufweisen. Die Ionenenergie muß mit Rücksicht auf eine hohe Maskenselektivität so klein wie möglich gehalten werden. Hohe Ionenenergien führen zudem zu störenden Rückwirkungen von zerstäubten oder abgetragenen und unkontrolliert redeponierten Materialien. Selbstverständlich muß die Energie der auf das Substrat einwirkenden Ionen ausreichen, um den Strukturgrund von Depositionen freizuhalten und so einen glatten Ätzgrund zu erzeugen.

## Patentansprüche

1. Verfahren zur Herstellung von geätzten Strukturen in Substraten mittels Plasmaatzens, wobei getrennt voneinander und alternierend ein an sich isotroper Plasmaätzvorgang und eine Plasma-Seitenwandpassivierung der structuren durchgeführt wird, wobei das Substrat (2) ein Polymer, ein Metall oder ein Mehrkomponentensystem ist und Anteile (8) der während der Seitenwandpassivierung aufgebrachten Seitenwandpassivierschicht (6) jeweils während der darauffolgenden Ätzvorgange auf noch nicht durch die bisher aufgebrachte Seitenwandpassivierschicht geschötzte Teile der Seitenflächen (7') der Seitenwand (7) übertragen werden, ohne daß dabei die Seitenwandpassivierung zerstört wird wodurch der Prozeß insgesamt anisotrop gemacht wird.

2. Verfahren nach Anspruch 1, **dadurch gekennzeichnet, daß** der Schrägeinfall von Ionen auf die Seitenwände der zu erstellenden Strukturen durch eine geeignete Kombination hoher Plasmadichte, niedrigem Prozeßdruck und niedriger Ionenbeschleunigung (-sspannung) gesteuert wird.

3. Verfahren nach Anspruch 1 oder 2, **dadurch gekennzeichnet, daß** das Substrat (2) während des Atzvorganges einem Einfall von Ionen mit niedriger Energie ausgesetzt wird.

4. Verfahren nach einem der Ansprüche 1 bis 3, **dadurch gekennzeichnet, daß** das Substrat (2) während der Seitenwandpassivierschritte einem Einfall von Ionen niedriger Energie ausgesetzt wird.

5. Verfahren nach einem der Ansprüche 1 bis 4, **dadurch gekennzeichnet, daß** während der Passierschritte die Ionenenergie so klein ist, daß sie keine effektive Ionenbeschleunigung bewirkt.

6. Verfahren nach einem der Ansprüche 1 bis 5, **dadurch gekennzeichnet, daß** die Seitenwandpassivierschicht (6) während der Ätzschritte durch einen relativ geringen, aber exakt kontrollierten Anteil schräg einfallender Ionen, vorzugsweise mit niedriger Energie, teilweise abgetragen, in Richtung des Ätzvorganges verlagert und so während des Ätzvorganges freigelegte Seitenflächen (7') geschützt werden.

7. Verfahren nach einem der Ansprüche 1 bis 6, **dadurch gekennzeichnet, daß** das Mehrkomponentensystem aus Gallium/Arsen oder Aluminium/Gallium/Arsen aufgebaut ist.

8. Verfahren nach einem der Ansprüche 1 bis 7, **dadurch gekennzeichnet, daß** das Polymer ein dicker Photoresist ("Photolack") oder ein Festresist ist.

9. Verfahren nach einem der Ansprüche 1 bis 8, **dadurch gekennzeichnet, daß** der Ätzvorgang mittels eines gegenüber dem zu ätzenden Medium spontan agierenden Ätzspezies durchgeführt wird.

10. Verfahren nach einem der Ansprüche 1 bis 9, **dadurch gekennzeichnet, daß** der Ätzvorgang mittels Chlor, Sauerstoff, einem fluorliefernden Gas, Sauerstoff zusammen mit einem fluorliefernden Gas, zum Beispiel Schwefelhexafluorid (SF₆), Stickstofftrifluorid (NF₃) oder Tetrafluormethan (CF₄) durchgeführt wird.

11. Verfahren nach Anspruch 10, **dadurch gekennzeichnet, daß** das fluorliefernde Gas mit Argon oder einem anderen Inertgas wie Helium oder Xenon versetzt wird.

12. Verfahren nach einem der Ansprüche 1 bis 11, **dadurch gekennzeichnet, daß** die Seitenwandpassivierung mittels Tetrachlorkohlenstoff (CCl₄), Trichlormethan (CHCl₃), CₓH_{y}Cl_{z}, BCl₃, Siliciumtetrachlorid (SiCl₄), Trifluormethan (CHF₃), Siliciumtetrafluorid SiF₄, Silan SiH₄ oder Gemischen aus Halogen-Kohlenwasserstoffen und SiF₄/SiCl₄, Silan SiH₄, Hexamethyldisilan (HMDS), Hexamethyldisiloxan (HMDSO), Hexamethyldisilazan (HMDSN), metallhaltigem Kohlenwasserstoff, Fluorkohlenwasserstoffen, Kohlenwasserstoff mit einem hohen Anteil aromatischer Ringe, perfluorierten Aromaten, perfluorierten Styrolderivaten oder Fluorätherverbindungen durchgeführt wird.

13. Verfahren nach einem der Ansprüche 1 bis 12, **dadurch gekennzeichnet, daß** die Ionenenergie während des Atzvorganges 10 bis 100 eV, vorzugsweise 30 bis 50 eV beträgt.

14. Verfahren nach einem der Ansprüche 1 bis 13, **dadurch gekennzeichnet, daß** die Ionenenergie während der Seitenwandpassivierung 10 bis 50 eV, vorzugsweise 30 - 40 eV beträgt.

15. Verfahren nach einem der Ansprüche 1 bis 14, **dadurch gekennzeichnet, daß** die Ionenenergie wahrend der Seitenwandpassivierung 0 - 10 eV beträgt und keine Biasspannung erzeugt wird.

16. Verfahren nach einem der Ansprüche 1 bis 15, **dadurch gekennzeichnet, daß** die für den Ätzvorgang und die Seitenwandpassivierung eingesetzten Medien während des Ioneneinfalls Gasflüsse von 10 bis 200 sccm und Prozeßdrücke von 10 bis 100 µbar (1 - 10 Pascal) aufweisen (im Auszustand jeweils 0).

17. Verfahren nach einem der Ansprüche 1 bis 16, **dadurch gekennzeichnet, daß** die Plasmaerzeugung durch Mikrowelleneinstrahlung beziehungsweise Hochfrequenzeinstellung (HF) bei Leistungen von 100 bis 1.500, vorzugweise 300 bis 1.200 Watt erfolgt.

18. Verfahren nach einem der Ansprüche 1 bis 17, **dadurch gekennzeichnet, daß** das Substrat während des Ätzvorganges und/oder der Passivierung der Seitenwand gekühlt wird.

19. Verfahren nach einem Ansprüche 1 bis 18, **dadurch gekennzeichnet, daß** der Ätzvorgang und die Passivierung mit einer hohen Plasmadichte an reaktiven Spezies und Ionen durchgeführt wird.

20. Verfahren nach einem der Anspruche 1 bis 19, **dadurch gekennzeichnet, daß** die Ionendichte, die Ionenenergie und die Relation geladener (= Ionen) zu ungeladener Teilchen (= Neutralspezies) unabhangig voneinander geregelt wird.

## Claims

1. Process for producing etched structures in substrates by means of plasma etching, in which, separately and alternately, an inherently isotropic plasma etching operation and a plasma side wall passivation of the structures are carried out, the substrate (2) being a polymer, a metal or a multicomponent system, and fractions (8) of the side wall passivation layer (6) applied during the side wall passivation in each case being transferred during the subsequent etching operations to parts of the side faces (7') of the side wall (7) which have not yet been protected by the side wall passivation layer previously applied, without the side wall passivation being destroyed in the process, with the result that, overall the process is made anisotropic.

2. Process according to Claim 1, **characterized in that** the oblique incidence of ions onto the side walls of the structures to be produced is controlled by a suitable combination of high plasma density, low process pressure and low ion acceleration (voltage).

3. Process according to Claim 1 or 2, **characterized in that** the substrate (2) is exposed to the incidence of low-energy ions during the etching operation.

4. Process according to one of Claims 1 to 3, **characterized in that** the substrate (2) is exposed to the incidence of low-energy ions during the side wall passivation steps.

5. Process according to one of Claims 1 to 4, **characterized in that** the ion energy is so low during the passivation steps that it does not produce any effective ion acceleration.

6. Process according to one of Claims 1 to 5, **characterized in that** the side wall passivation layer (6), during the etching steps, by means of a relatively small but accurately controlled level of obliquely impinging ions, preferably with a low energy, is partially abraded, displaced towards the etching operation, and in this way side faces (7') which have been uncovered during the etching operation are protected.

7. Process according to one of Claims 1 to 6, **characterized in that** the multicomponent system is composed of gallium/arsenic or aluminium/gallium/arsenic.

8. Process according to one of Claims 1 to 7, **characterized in that** the polymer is a thick photoresist or a solid resist.

9. Process according to one of Claims 1 to 8, **characterized in that** the etching operation is carried out by means of an etching species which acts spontaneously with respect to the medium to be etched.

10. Process according to one of Claims 1 to 9, **characterized in that** the etching operation is carried out by means of chlorine, oxygen, a gas which delivers fluorine, oxygen together with a gas which delivers fluorine, for example sulphurhexafluoride (SF₆), nitrogentrifluoride (NF₃) or tetrafluoromethane (CF₄).

11. Process according to Claim 10, **characterized in that** the gas which delivers fluorine is mixed with argon or another inert gas, such as helium or xenon.

12. Process according to one of Claims 1 to 11, **characterized in that** the side wall passivation is carried out by means of carbon tetrachloride (CCl₄), trichloromethane (CHCl₃), CₓH_{y}Cl_{z}, BCl₃, silicon tetrachloride (SiCl₄), trifluoromethane (CHF₃), silicon tetrafluoride SiF₄, silane SiH₄ or mixtures of halogen hydrocarbons and SiF₄/SiCl₄, silane SiH₄, hexamethyldisilane (HMDS), hexamethyldisiloxane (HMDSO), hexamethyldisilazane (HMDSN), metal-containing hydrocarbon, fluorinated hydrocarbons, hydrocarbon with a high level of aromatic rings, perfluorinated aromatics, perfluorinated styrene derivatives or fluorine ether compounds.

13. Process according to one of Claims 1 to 12, **characterized in that** the ion energy during the etching operation is from 10 to 100 eV, preferably 30 to 50 eV.

14. Process according to one of Claims 1 to 13, **characterized in that** the ion energy during the side wall passivation is 10 to 50 eV, preferably 30-40 eV.

15. Process according to one of Claims 1 to 14, **characterized in that** the ion energy during the side wall passivation is 0-10 eV, and no bias voltage is generated.

16. Process according to one of Claims 1 to 15, **characterized in that** the media used for the etching operation and the side wall passivation during the ion impingement have gas flow rates of from 10 to 200 sccm and process pressures of from 10 to 100 µbar (1-10 Pascal) (in each case 0 in the off state).

17. Process according to one of Claims 1 to 16, **characterized in that** the plasma is generated by microwave irradiation or by setting a radio frequency (RF) at powers of from 100 to 1500, preferably 300 to 1200, watts.

18. Process according to one of Claims 1 to 17, **characterized in that** the substrate is cooled during the etching operation and/or the passivation of the side wall.

19. Process according to one of Claims 1 to 18, **characterized in that** the etching operation and the passivation are carried out with a high plasma density of reactive species and ions.

20. Process according to one of Claims 1 to 19, **characterized in that** the ion density, the ion energy and the relationship between charged (= ions) and uncharged particles (= neutral species) are regulated independently of one another.

## Revendications

1. Procédé de fabrication de structures gravées dans des substrats par gravure au plasma, selon lequel on effectue séparément l'une de l'autre en alternance, une opération de gravure au plasma en elle-même isotrope et une passivation au plasma de paroi latérale des structures, selon lequel
le substrat (2) est un polymère, un métal ou un système multi-composants, et des parties (8) de la couche de passivation de paroi latérale (6) déposées pendant la passivation de paroi latérale chaque fois pendant les opérations de gravure suivantes sont transférées sur des parties des surfaces latérales (7') de la paroi latérale (7) non encore protégées par la couche de passivation de paroi latérale appliquée jusqu'à présent, sans qu'à cette occasion la passivation de paroi latérale soit détruite, moyennant quoi le processus est rendu globalement anisotrope.

2. Procédé selon la revendication 1,
**caractérisé en ce que**
l'incidence oblique d'ions sur les parois latérales de structures à fabriquer est commandée par une combinaison appropriée de hautes densités de plasma, d'une basse pression de processus et d'une faible accélération (tension) des ions.

3. Procédé selon la revendication 1 ou 2,
**caractérisé en ce que**
le substrat (2) est exposé à une incidence d'ions de faible énergie pendant l'opération de gravure.

4. Procédé selon l'une quelconque des revendications 1 à 3,
**caractérisé en ce que**
pendant les étapes de passivation de paroi latérale, le substrat (2) est exposé à une incidence d'ions de faible énergie.

5. Procédé selon l'une quelconque des revendications 1 à 4,
**caractérisé en ce que**
pendant les étapes de passivation l'énergie des ions est tellement petite qu'elle ne provoque par d'accélération réelle des ions.

6. Procédé selon l'une quelconque des revendications 1 à 5,
**caractérisé en ce que**
la couche de passivation de paroi latérale (6) est partiellement érodée pendant les étapes de gravure par une proportion relativement petite mais contrôlée avec précision d'ions d'incidence oblique, de préférence de faible énergie, et déplacée en direction de l'opération de gravure et, ainsi des surfaces latérales (7') mises à jour pendant de l'opération de gravure sont protégées.

7. Procédé selon l'une quelconque des revendications 1 à 6,
**caractérisé en ce que**
le système multi-composants est élaboré à partir de gallium/arsenic ou d'aluminium/gallium / arsenic.

8. Procédé selon l'une quelconque des revendications 1 à 7,
**caractérisé en ce que**
le polymère est une laque photosensible épaisse (photorésist) ou un résist de fixation.

9. Procédé selon l'une quelconque des revendications 1 à 8,
**caractérisé en ce que**
l'opération de gravure est réalisée au moyen d'un type de gravures agissant spontanément sur le milieu à graver.

10. Procédé selon l'une quelconque des revendications 1 à 9,
**caractérisé en ce que**
l'opération de gravure est réalisée au moyen de chlore, d'oxygène, d'un gaz délivrant du fluor, d'oxygène avec un gaz délivrant du fluor, par exemple, de l'hexafluorure de souffre (SF₆), du trifluorure d'azote (NF₃) ou du tétrafluorométhane (CF₄).

11. Procédé selon la revendication 10,
**caractérisé en ce que**
le gaz délivrant du fluor est mélangé avec de l'argon ou un autre gaz inerte tel de l'hélium ou du xénon.

12. Procédé selon l'une quelconque des revendications 1 à 11,
**caractérisé en ce que**
la passivation de paroi latérale est réalisée au moyen de tétrachlorure de carbone (CCl₄) de trichlorométhane (CHCl₃), de CₓC_{y}Cl_{z}, de BCl₃, de tétrachlorure de silicium (SiCl₄), de trifluorométhane (CHF₃), de tétrafluorure de silicium (SiF₄), de silane (SiH₄) ou de mélanges d'hydrocarbures halogénés et SiF_{4/}SiCl₄, de silane (SiH₄), d'héxaméthyldisilane (HMDS), d'héxaméthyldisiloxane (HMDSO), d'héxaméthyldisilazane (HMDSN), d'hydrocarbures contenant du métal, d'hydrocarbures fluorés, d'hydrocarbures possédant une forte proportion de cycles aromatiques, d'aromates perfluorés, de dérivés perfluorés du styrol, ou de composés fluor - éther.

13. Procédé selon l'une quelconque des revendications 1 à 12,
**caractérisé en ce que**
l'énergie des ions, pendant le processus de gravure, est comprise entre 10 et 100 eV, de préférence entre 30 et 50 eV.

14. Procédé selon l'une quelconque des revendications 1 à 13,
**caractérisé en ce que**
l'énergie des ions, pendant la passivation de paroi latérale, est comprise entre 10 et 50 eV, de préférence entre 30 et 40 eV.

15. Procédé selon l'une quelconque des revendications 1 à 14,
**caractérisé en ce que**
l'énergie des ions, pendant la passivation de paroi latérale, est comprise entre 0 et 10 eV et qu'aucune tension de polarisation n'est créée.

16. Procédé selon l'une quelconque des revendications 1 à 15,
**caractérisé en ce que**
les milieux utilisés pour l'opération de gravure et la passivation de paroi latérale pendant l'incidence d'ions, présentent des écoulements de gaz de 10 à 200 sccm et des pressions de processus de 10 à 100 µbar (1 à 10 pascals, toujours 0 à l'état d'arrêt).

17. Procédé selon l'une quelconque des revendications 1 à 16,
**caractérisé en ce que**
la génération de plasma s'effectue par rayonnement micro-onde ou un réglage haute fréquence (HF) avec des puissances de 100 à 1 500, de préférence 300 à 1 200 watts.

18. Procédé selon l'une quelconque des revendications 1 à 17,
**caractérisé en ce que**
pendant le processus de gravure et/ou de passivation de paroi le substrat est refroidi.

19. Procédé selon l'une quelconque des revendications 1 à 18,
**caractérisé en ce que**
l'opération de gravure et la passivation s'effectuent avec un plasma à haute densité d'espèces réactives et d'ions.

20. Procédé selon l'une quelconque des revendications 1 à 19,
**caractérisé en ce que**
la densité d'ions, l'énergie des ions et la relation particules chargées (= ions) et particules non chargées (= espèces neutres) sont régulées indépendamment les unes des autres.
